# EUROPEAN PATENT SPECIFICATION

(11) **EP 0 761 831 B1**
(45) Date of publication and mention of the grant of the patent: **13.06.2001**
(21) Application number: 96304889.7
(22) Date of filing: 02.07.1996
(51) Int. Cl.: C22C 5/02, H01L 23/49

(54) **Thin gold alloy wire for bonding**
Dünner Golddraht zum Bonden
Fil d'or fin pour connexion

(30) Priority: 23.08.1995 JP 21478895
(43) Date of publication of application: 12.03.1997
(73) Proprietor: TANAKA DENSHI KOGYO KABUSHIKI KAISHA, Chuoh-ku, Tokyo (JP)
(72) Inventor: Itabashi, Ichimitsu, c/o Mitaka Fact. of, Mitaka-shi, Tokyo (JP); Mimura, Toshitaka, c/o Mitaka Fact. of, Mitaka-shi, Tokyo (JP)
(74) Representative: Denmark, James

(56) References cited:
- EP-A- 0 530 968
- FR-A- 2 530 512
- US-A- 4 938 923
- PATENT ABSTRACTS OF JAPAN vol. 018, no. 388 (E-1581), 20 July 1994 & JP-A-06 112258 (TANAKA DENSHI KOGYO KK), 22 April 1994,
- PATENT ABSTRACTS OF JAPAN vol. 014, no. 288 (E-0943), 21 June 1990 & JP-A-02 091944 (MITSUBISHI METAL CORP), 30 March 1990,
- PATENT ABSTRACTS OF JAPAN vol. 018, no. 388 (E-1581), 20 July 1994 & JP-A-06 112251 (TANAKA DENSHI KOGYO KK), 22 April 1994,

## Description

### BACKGROUND OF THE INVENTION

The present invention relates to a method of manufacturing a thin gold alloy wire for bonding which is to be used for the wiring (connection) of an electrode of a semiconductor chip and an outer lead and more particularly to a method of manufacturing a thin gold alloy wire for semiconductor chip bonding which is useful for a high-density mounting of a semiconductor device.

Heretofore, for the wiring of an electrode of a semiconductor chip and an outer lead, there has been used a thin gold alloy wire comprising gold of a high purity and 1 to 100 wt ppm of trace elements and having a diameter of 25 to 50 µm.

For the wiring of a semiconductor chip and an outer lead by using such a thin wire, there usually is adopted what is called a ball bonding method wherein the front end of the thin wire is heated and melted by electric discharge to form a ball and then the ball is compression-bonded to an electrode of the semiconductor chip to effect connection of the thin wire and the electrode.

However, with the, recent trend to further reduction in size and higher density of a semiconductor device, the number of electrodes of a semiconductor chip increases and hence it is required to decrease the electrode area. But in the aforesaid ball bonding method the ball diameter (twice or so as large as the thin wire diameter) is proportional to the thin wire diameter, so a limit is encountered in decreasing the electrode area to increase the number of electrodes.

For solving this problem, if the thin wire diameter is merely made smaller than in the prior art so as to reduce the ball diameter, the strength of thin wire will be deteriorated due to the reduced wire diameter, thus resulting in increase in the percentage breaking of the wire to an impracticable extent during wiring and during use of the semiconductor device concerned.

In view of the above point, in Japanese Patent Laid Open No.310557/1994, there is proposed a thin wire using a so-called clad material which comprises an Au alloy as a core and a coating metal, the coating metal being Au or an Au alloy of a lower alloy components content than the core. According to the unexamined publication, such thin wire can be enhanced its strength even at a wire diameter of 10 to 20 µm.

However, the thin wire clad with materials of different qualities involves a problem of deterioration in characteristics, especially deterioration in bonding strength, after left standing for a long time in a high temperature condition of 200° C or so.

On the other hand, with a view to meeting the foregoing requirement it is disclosed in Japanese Patent Laid-Open No.112251/1994 that by incorporating Pd and Pt in Au in an amount of up to 5 wt% it is made possible to not only attain a higher strength of the resulting thin gold alloy wire but also keep low the deterioration in bonding strength after left standing for a long time in a high 'temperature condition of 200 ° C or so.

In the case of using such thin wire as a bonding wire, it is effective in enhancing the strength and suppressing the deterioration in bonding strength between a ball and a semiconductor chip electrode after left standing for a long time in a high temperature condition, as mentioned above. However, although the alloy of the above composition is a high strength alloy, it involves the problem that the percentage breaking of the wire is high when the wire is subjected to vibration.

Thus, in wiring an electrode of a semiconductor chip such as an IC chip for example and an outer lead through a thin gold alloy wire, and when the area of the semiconductor chip electrode becomes smaller to cope with the recent trend to the reduction in size and enhancement of density of a semiconductor device, it is necessary to decrease the diameter of the thin gold alloy wire.

It is an object of the present invention to provide a method of manufacturing a thin gold alloy wire for semiconductor chip bonding having a high strength in spite of a smaller diameter than in the prior art, capable of decreasing the percentage breaking during wiring and during use, capable of keeping low the deterioration in bonding strength between a ball and a semiconductor chip electrode after left standing for a long time in a high temperature condition, capable of suppressing the breaking of the wire when subjected to vibration, and extremely useful in reducing the size of a semiconductor device and attaining a higher density of the same device.

Having made studies earnestly, the inventors of the present invention found out that a method involving incorporating Pd, Pt, etc. in predetermined amounts into Au including incidental impurity to afford a specific alloy composition, melting and casing the gold alloy, and subjecting the resulting ingot to rolling, drawing and annealing into a gold alloy wire having an elongation of 3% to 8% after the annealing and also having a high Young's modulus, is effective in solving the foregoing problems. Further, the inventors of the present invention found out that by suppressing in the above specific alloy composition the formation of a chilled layer in the ingot during casting and by subjecting the ingot to rolling, drawing and annealing there can be obtained a thin gold alloy wire having an elongation of 3% to 8% after the annealing which is required for the ordinary thin gold alloy wire for bonding and nonetheless having a high Young's modulus. In this way we accomplished the present invention.

### SUMMARY OF THE INVENTION

According to the invention there is provided a method of manufacturing a gold alloy wire as provided in claim 1.

### BRIEF DESCRIPTION OF THE DRAWING

Fig. 1 is a schematic diagram showing an example of a method for obtaining an ingot of a thin gold alloy wire for bonding according to the present invention; and
Fig. 2 is a schematic diagram showing a conventional method for obtaining an ingot of a thin gold alloy wire for bonding.

### DETAILED DESCRIPTION OF THE PREFERRED EMBODIMENTS

The present invention will be described in detail hereinunder.

It is necessary that the thin gold alloy wire for semiconductor chip bonding provided by the present invention consists essentially of from at least one of Pt and Pd in the amount specified above, at least one of Be, Ge, Ca, La, Y and Eu in the foregoing amount and the balance being Au and incidental impurity and have an elongation of 3% to 8% and a Young's modulus of 66,687 to 88,263 MPa (6,800 to 9,000 kgf/mm²).

By using at least one of Pt and Pd and at least one of Be, Ge, Ca, La, Y and Eu in the respective amounts specified above, the resulting synergistic effect of the two not only improves the breaking strength of the thin gold alloy wire but also makes it possible to suppress the deterioration in bonding strength between a ball and a semiconductor chip electrode after left standing for a long time in a high temperature condition.

It is presumed that the deterioration of bonding strength is suppressed because an interdiffusion of the gold alloy which constitutes the ball and Al of the semiconductor chip electrode is performed to a moderate extent.

If at least one of Pd and Pt is contained in an amount exceeding 2.2 wt%, not only the semiconductor chip is apt to be cracked but also the percentage breaking under vibration becomes high. And if the content of at least one of Pd and Pt is lower than 0.1 wt%, there will be obtained neither the high breaking strength of 20 kgf/mm² or more as in the present invention nor the foregoing bonding strength after left standing for a long time in a high temperature condition. For this reason it is necessary that at least one of Pd and Pt be contained in an amount in the range from 0.1 to 2.2 wt%.

If at least one of Be, Ge, Ca, La, Y and Eu, which is added in addition to the aforesaid amount of Pd and/or Pt, is contained in an amount exceeding 0.005 wt%, the semiconductor chip becomes more likely to be cracked at the time of ball bonding. And if the content of at least one of Be, Ge, Ca, La, Y and Eu is lower than 0.0001 wt%, such a high breaking strength of 20 kgf/mm² as in the present invention will not be attained.

Therefore, it is necessary that at least one of Be, Ge, Ca, La, Y and Eu be contained in an amount of 0.0001 to 0.005 wt% in addition to the foregoing amount of Pd and/or Pt.

The following description is now provided about a manufacturing process for obtaining a thin gold alloy wire of the foregoing composition and having an elongation of 3% to 8% and a high Young's modulus.

An outline of the manufacturing process will first be given. Ingot which has been obtained by melting and casing a gold alloy of a composition falling under the scope of the invention is subjected to a rough machining such as rolling with grooved rolls for example, followed by drawing preferably to a diameter of 3 to 24 *µ* m and annealing to an elongation of 3% to 8%, afford a thin gold alloy wire.

In obtaining the ingot by melting and casing a gold alloy of a composition by the invention, the formation of a chilled layer in the ingot is prevented, and by using the ingot as the starting material there can be obtained a thin gold alloy wire having an elongation of 3% to 8% after annealing and yet having a high Young's modulus. By virtue of a synergistic effect of the above alloy composition and high Young's modulus there is attained an excellent anti-vibration effect which is to be achieved in the invention.

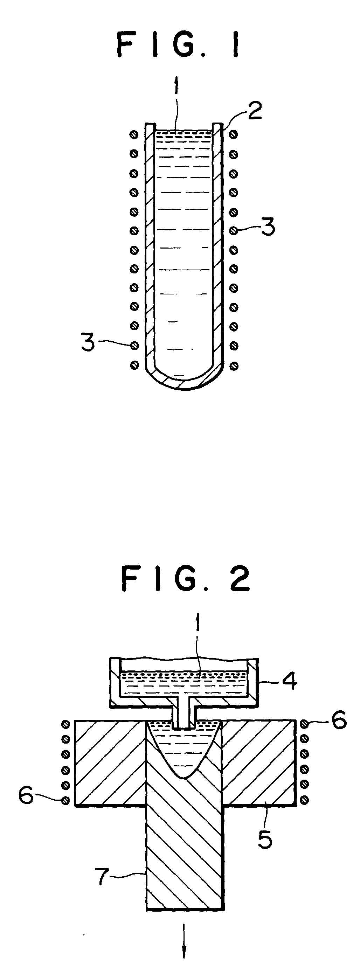

With reference to Fig. 1, description is now directed to an example of a method for obtaining an ingot with suppressed formation of a chilled layer by melting and casting a gold alloy of a composition falling under the composition specified in the invention. In Fig. 1, the reference numeral 1 denotes a molten gold alloy numeral 2 denotes a cylindrical graphite crucible, and numeral 3 denotes a high frequency heating coil.

First, using the high frequency heating coil 3, the gold alloy is melted within the cylindrical graphite crucible 2 to afford molten gold alloy 1.

Then, the high frequency heating coil 3 is moved upward from the lower end of the crucible 2 at a predetermined speed, allowing the molten gold alloy 1 to be solidified within the crucible 2. In this case, the molten gold alloy solidifying speed is set at 80 mm/min or lower, preferably 50 mm/min or lower.

By so solidifying the molten gold alloy 1 within the crucible 2 from the lower end toward the upper end of the crucible it is made possible to prevent the formation of a chilled layer on the ingot surface.

In the present invention, the ingot thus obtained by the above intra-crucible solidifying method is used as the starting material, whereby a thin gold alloy wire having the above composition and having after annealing an elongation of 3% to 8% and a high Young's modulus can be obtained positively and that relatively easily.

Reference will now be made to Fig. 2 for explaining a continuous casting method as a conventional ingot producing method. In the same figure, the numeral 1 denotes molten gold alloy, numeral 4 denotes a tundish, numeral 5 a graphite mold, numeral 6 a water-cooling pipe for cooling the graphite mold, numeral 7 a solidified ingot, and the arrow represents an ingot pulling direction.

First, the molten gold alloy 1 is poured into the graphite mold 5 while adjusting the amount thereof with the tundish 4. The graphite mold 5 is cooled by the water-cooling pipe 6 which is kept in contact with the mold. Consequently, the molten gold alloy 1 is cooled forcibly by the graphite mold 5 and solidifies, then the thus-solidified mass is pulled out in the arrowed direction.

Heretofore, as an ingot making method in the production of a thin gold alloy wire for bonding, there has usually been adopted the continuous casting method of Fig. 2 which permits a high production rate and hence affords a high productivity. According to this conventional method, graphite or copper for example is used as the material of the mold and the molten gold alloy is solidified at a rate of 300 mm/min or higher. By so doing, since the molten gold alloy 1 is cooled forcibly by the mold 5, there is formed a chilled layer in the ingot surface portion and therefore the subsequent drawing work does not afford a thin gold alloy wire of a high Young's modulus after annealing.

Even when an ingot obtained by the foregoing intra-crucible solidifying method and having a chilled layer-free surface is used as the starting material, the subsequent drawing work will not afford a thin gold alloy wire of a high Young's modulus after annealing.

As mentioned previously, the thin gold alloy wire produced according to the present invention is subjected to an annealing treatment to an elongation of 3% to 8% like the ordinary thin gold alloy wires for bonding.

Although the elongation before annealing is 1% to 2%, it increases to 3% to 8% after annealing.

Further, by producing an ingot with suppressed formation of a chilled layer as noted above from the gold alloy of the composition specified herein and then subjecting it to a rough machining, drawing and annealing into a thin gold alloy wire, there is attained a Young's modulus of 66,687 to 88,263 MPa (6,800 to 9,000 kgf/mm²).

Usually, a thin gold alloy wire for bonding is used after annealing to an elongation of 3% to 8%.

Even by adopting the foregoing ingot making method it is difficult for the Young's modulus after annealing to exceed 88,263 MPa (9,000 kgf/mm²). For this reason the Young's modulus after annealing has been set at 66,687 to 88,263 MPa (6,800 to 9,000 kgf/mm²).

Even after the gold alloy wire made according to the present invention is subjected to annealing to an elongation of 3% to 8%, there is attained a Young's modulus as high as 66,687 to 88,263 MPa (6,800 to 9,000 kgf/mm²).

The reason why the thin gold alloy wire produced from such gold alloy composition and having such high Young's modulus can reduce the percentage breaking of the wire under vibration, in addition to exhibiting the foregoing effect of improving the breaking strength and suppressing the deterioration of bonding strength, is not clear, but is presumed to be as follows.

The reason why the wire made according to the present invention affords a high Young's modulus even after annealing is presumed that not only the alloy composition improves the breaking strength but also the ingot used as the starting material is with suppressed formation of a chilled layer and therefore by a synergistic effect of the two the inner and outer surfaces of the thin gold alloy wire are improved in uniformity.

Further, the reason why the thin gold alloy wire of a high Young's modulus produced according to the present invention can decrease the percentage breaking of the wire under vibration, in addition to exhibiting improvement of the breaking strength and suppressing the deterioration in bonding strength is presumed that the aforesaid improvement in uniformity of the inner and outer surfaces of the thin gold alloy wire can prevent the occurrence of a weak point on the surface portion.

### Examples

The present invention will be described below in more detail by way of working example.

### (Example 1)

A predetermined amount of alloy elements were added to a high-purity gold of 99.99 wt% or higher in purity, then after high-frequency melting within the cylindrical graphite crucible 1 illustrated in Fig. 1, the high-frequency heating coil 3 was moved from the lower end toward the upper end of the graphite crucible 2 at a rate of 50 mm/min, allowing the molten gold alloy 1 to solidify into ingot within the graphite crucible 2. The ingot was found to have no chilled layer.

The ingot was then subjected to rolling with grooved rolls, subsequent drawing into a diameter of 20 *µ* m, and annealing to an elongation of 4%, to give a thin gold alloy wire whose alloy composition is shown in Table 1, namely 0.1% by weight of Pd, 0.0005% by weight of Be and the balance being Au and incidental impurity. Young's modulus of the thin wire was 66,687 MPa (6,800 kgf/mm²) as shown in Table 2.

The thin wire was then determined for breaking strength, percent rupture of a bonded portion after left standing at 200 ° C for 2,000 hours, percent breaking of the wire under vibration, and IC chip cracking in bonding, the results of which are as set forth in Table 3. The measurements were conducted in the following manner.

### (Breaking Strength)

A tension test was conducted at a gauge length of 100 mm and at a pulling rate of 10 mm/min.

### (Percent Rupture of Bonded Portion)

The thin gold alloy wire produced as above was ball-bonded onto a thin aluminum film of 0.8 *µ* m in thickness as a semiconductor chip electrode and then left standing at 200° C for 2,000 hours. Subsequently there was conducted a so-called pulling test wherein the semiconductor chip portion was fixed and the wire portion was pulled, and a check was made to see in which of the bonded portion and the thin gold alloy portion there occurred breakage. The test was performed for 100 samples and the number of samples each ruptured in the bonded portion was used as the percent rupture of the bonded portion.

### (Percent Breaking under Vibration)

Five bonded samples were prepared each by bonding an IC chip electrode and a 200-pin frame using an automatic high-speed bonder. The samples were then put into a cassette, which in turn was fixed to a vibration tester and vibrated 1 hour at a frequency of 50 Hz and a gravitational acceleration of 2.5G. Thereafter, the bonded portions were each'checked for breaking by means of an optical microscope, and the percentage of the number of broken wires was used as the percent breaking under vibration.

### (IC Chip Cracking)

The foregoing thin gold alloy wire was bonded to an IC chip electrode using an automatic high-speed bonder, and the thus-bonded sample was then observed with an optical microscope to check whether there was any cracking of the IC chip.

### (Examples 2 - 18 and Comparative Examples 1 - 5)

Tests were conducted in the same way as in Example 1 except that there were used the thin Au alloy wire composition, ingot cooling speeds, thin wire diameters, and elongations and Young's moduli, as shown in Tables 1 and 2. The results of the tests are as set out in Table 3.

### (Comparative Examples 6 - 11)

Tests were conducted in the same way as in Example 1 except that there were used the thin Au alloy wire composition and Young's moduli as shown in Tables 1 and 2 and that ingots were produced by the conventional continuous casting method at a pulling rate of 300 mm/min using a graphite mold which was cooled by contact therewith of a water-cooling pipe, in place of the intra-crucible solidifying method involving melting and solidifying gold alloys within a graphite crucible. The pulling rate was shown as the solidifying rate in Table 2. Chilled layers were formed in the ingots.

The results of the tests are as set out in Table 3.

**Table 1**

| | How to Manufacture | | | | | | | | |
|---|---|---|---|---|---|---|---|---|---|
| | Composition ( ppm by weight ) | | | | | | | | |
| Example | Pd | Pt | Be | Ge | Ca | La | Y | Eu | Au |
| 1 | 0.1 × 10⁴ | - | 5 | - | - | - | - | - | balance |
| 2 | 1.0 ×10⁴ | - | 5 | - | - | - | - | - | balance |
| 3 | 2.2 ×10⁴ | - | 5 | - | - | - | - | - | balance |
| 4 | - | 0.1 ×10⁴ | 5 | - | - | - | - | - | balance |
| 5 | - | 1.0 ×10⁴ | 5 | - | - | - | - | - | balance |
| 6 | - | 2.2 ×10⁴ | 5 | - | - | - | - | - | balance |
| 7 | 1.0 ×10⁴ | 1.0 ×10⁴ | 5 | - | - | - | - | - | balance |
| 8 | 1.0 ×10⁴ | - | - | 20 | - | - | - | - | balance |
| 9 | 1.0 ×10⁴ | - | - | - | 20 | - | - | - | balance |
| 10 | 1.0 ×10⁴ | - | - | - | - | 20 | - | - | balance |
| 11 | 1.0 ×10⁴ | - | - | - | - | - | 20 | - | balance |
| 12 | 1.0 ×10⁴ | - | - | - | - | - | - | 20 | balance |
| 13 | 1.0 ×10⁴ | - | 5 | - | - | - | - | - | balance |
| 14 | 1.0 ×10⁴ | - | 5 | - | - | - | - | - | balance |
| 15 | 1.0 ×10⁴ | - | 5 | - | - | - | - | - | balance |
| 16 | 1.0 ×10⁴ | - | 5 | - | - | - | - | - | balance |
| 17 | 1.0 ×10⁴ | - | 5 | - | - | - | - | - | balance |
| 18 | 1.0 ×10⁴ | - | 5 | - | - | - | - | - | balance |

| Comparative -Example | | | | | | | | | |
|---|---|---|---|---|---|---|---|---|---|
| 1 | - | - | - | - | - | - | 20 | - | balance |
| 2 | 0.05×10⁴ | - | 5 | - | - | - | - | - | balance |
| 3 | - | 0.05×10⁴ | 5 | - | - | - | - | - | balance |
| 4 | 3.0 ×10⁴ | - | 5 | - | - | - | - | - | balance |
| 5 | - | 3.0 ×10⁴ | 5 | - | - | - | - | - | balance |
| 6 | 0.1 ×10⁴ | - | 5 | - | - | - | - | - | balance |
| 7 | 1.0 ×10⁴ | - | 5 | - | - | - | - | - | balance |
| 8 | 2.2 ×10⁴ | - | 5 | - | - | - | - | - | balance |
| 9 | - | 0.1 ×10⁴ | 5 | - | - | - | - | - | balance |
| 10 | - | 1.0 ×10⁴ | 5 | - | - | - | - | - | balance |
| 11 | - | 2.2 ×10⁴ | 5 | - | - | - | - | - | balance |

**Table 2**

| Example | H o w t o Manufacture | | | | Test Results | |
|---|---|---|---|---|---|---|
| | Ingot | | | Thin Wire Diameter (*µ*m) | Elong -ation (%) | Young's |
| | Solidifying Method | Solidifying Rate(mm/min) | Chilled Layer | | | Modulus (MPa) |
| 1 | Intra-crucible Solidifying | 50 | No | 20 | 4 | 66,687 |
| 2 | Intra-crucible Solidifying | 50 | No | 20 | 4 | 76,494 |
| 3 | Intra-crucible Solidifying | 50 | No | 20 | 4 | 88,263 |
| 4 | Intra-crucible Solidifying | 50 | No | 20 | 4 | 66,687 |
| 5 | Intra-crucible Solidifying | 50 | No | 20 | 4 | 75,513 |
| 6 | Intra-crucible Solidifying | 50 | No | 20 | 4 | 88,263 |
| 7 | Intra-crucible Solidifying | 50 | No | 20 | 4 | 83,359 |
| 8 | Intra-crucible Solidifying | 50 | No | 20 | 4 | 75,513 |
| 9 | Intra-crucible Solidifying | 50 | No | 20 | 4 | 77,475 |
| 10 | Intra-crucible Solidifying | 50 | No | 20 | 4 | 71,159 |
| 11 | Intra-crucible Solidifying | 50 | No | 20 | 4 | 72,257 |
| 12 | Intra-crucible Solidifying | 50 | No | 20 | 4 | 76,494 |
| 13 | Intra-crucible Solidifying | 80 | No | 20 | 4 | 66,687 |
| 14 | Intra-crucible Solidifying | 10 | No | 20 | 4 | 82,378 |
| 15 | Intra-crucible Solidifying | 50 | No | 15 | 4 | 76,494 |
| 16 | Intra-crucible Solidifying | 50 | No | 24 | 4 | 76,494 |
| 17 | Intra-crucible Solidifying | 50 | No | 20 | 3 | 78,456 |
| 18 | Intra-crucible Solidifying | 50 | No | 20 | 8 | 68,649 |

| Comparative -Example | | | | | | |
|---|---|---|---|---|---|---|
| 1 | Intra-crucible Solidifying | 50 | No | 20 | 4 | 56,880 |
| 2 | Intra-crucible Solidifying | 50 | No | 20 | 4 | 56,880 |
| 3 | Intra-crucible Solidifying | 50 | No | 20 | 4 | 56,880 |
| 4 | Intra-crucible Solidifying | 50 | No | 20 | 4 | 88,263 |
| 5 | Intra-crucible Solidifying | 50 | No | 20 | 4 | 88,263 |
| 6 | Continuous Casting | 300 | Yes | 20 | 4 | 57,861 |
| 7 | Continuous Casting | 300 | Yes | 20 | 4 | 61,784 |
| 8 | Continuous Casting | 300 | Yes | 20 | 4 | 63,745 |
| 9 | Continuous Casting | 300 | Yes | 20 | 4 | 57,861 |
| 10 | Continuous Casting | 300 | Yes | 20 | 4 | 61,784 |
| 11 | Continuous Casting | 300 | Yes | 20 | 4 | 63,745 |

**T a b l e 3**

| Example | Test Results | | | |
|---|---|---|---|---|
| | Breaking Strength (kgf/mm ²) | Percent Rupture of Bonded Portion after standing at 200 °C (%) | Percent Breaking under Vibration (%) | IC Chip Cracking in Bonding |
| 1 | 22 | 0 | 0 | No |
| 2 | 25 | 0 | 0 | No |
| 3 | 30 | 0 | 0 | No |
| 4 | 22 | 0 | 0 | No |
| 5 | 24 | 0 | 0 | No |
| 6 | 32 | 0 | 0 | No |
| 7 | 33 | 0 | 0 | No |
| 8 | 24 | 0 | 0 | No |
| 9 | 26 | 0 | 0 | No |
| 10 | 23 | 0 | 0 | No |
| 11 | 23 | 0 | 0 | No |
| 12 | 26 | 0 | 0 | No |
| 13 | 24 | 0 | 0 | No |
| 14 | 28 | 0 | 0 | No |
| 15 | 25 | 0 | 0 | No |
| 16 | 24 | 0 | 0 | No |
| 17 | 30 | 0 | 0 | No |
| 18 | 21 | 0 | 0 | No |

| Comparative -Example | | | | |
|---|---|---|---|---|
| 1 | 14 | 80 | 0 | No |
| 2 | 18 | 40 | 0 | No |
| 3 | 18 | 40 | 0 | No |
| 4 | 32 | 0 | 20 | Yes |
| 5 | 33 | 0 | 20 | Yes |
| 6 | 21 | 0 | 70 | No |
| 7 | 23 | 0 | 50 | No |
| 8 | 26 | 0 | 40 | No |
| 9 | 22 | 0 | 60 | No |
| 10 | 23 | 0 | 50 | No |
| 11 | 25 | 0 | 40 | No |

From the above test results it is seen that the thin gold alloy wires of Examples 1 to 18 made according to the present invention and having an elongation of 3 to 8 % and Young's modulus of 6,800 to 9,000 kgf/mm² after annealing, even in spite of smaller diameters than in the prior art, exhibit effects equal or superior to the conventional thin gold alloy wires for bonding in all of breaking strength, percent rupture of bonded portion after left standing at a high temperature for a long time, percent breaking under vibration and IC chip cracking in bonding. Thus, it turned out that the subject of the present invention could be achieved.

In contrast therewith, Comparative Examples 1 to 3 are inferior to the above working Examples in point of breaking strength and bonding reliability after standing at a high temperature, and Comparative Examples 4 and 5 are inferior to the above working Examples in point of percent breaking under vibration and IC chip cracking. Further, Comparative Examples 6 to 11 are inferior to the above working Examples in point of percent breaking under vibration. Thus, it turned out that those comparative examples could not achieve the subject of the present invention.

From a comparison between the working Examples of the present invention and Comparative Examples 1-5 it also turned out that even when an ingot obtained by the foregoing intra-crucible solidifying method and not having a chilled layer in its surface portion was used as the starting material, if its alloy composition did not fall under the specified composition, a subsequent drawing of the ingot could not afford a thin gold alloy wire of a high Young's modulus after annealing, thus making it impossible to achieve the subject of the present invention.

Further, from a comparison between Examples 1-3 and Comparative Examples 6-8 and a comparison between Examples 4-6 and Comparative Examples 9-11 it turned out that the working Examples of the present invention adopting the intra-crucible solidifying method which involves cooling molten gold alloy within the crucible from the upper end toward the lower end of the crucible could afford positively and relatively easily a thin gold alloy wire having after annealing an elongation of 3 to 8 % and a high Young's modulus.

As set forth hereinabove, the thin gold alloy wire for semiconductor chip bonding made recording to the present invention is obtained from an alloy composition consisting essentially of predetermined amounts of elements selected from Pt, Pd, Be, Ge, Ca, La, Y and Eu and the balance being Au and incidental impurity and having an elongation of 3 to 8 % and a Young's modulus of 6,800 to 9,000 kgf/mm². Therefore, by virtue of a synergistic effect of both such alloy composition and high Young's modulus and the method used there is attained a predetermined strength and hence it is possible to decrease the occurrence of wire breaking during wiring and use even if the wire diameter is made small. Besides, the deterioration of the bonding strength between a ball and a semiconductor chip electrode after standing for a long time in a high temperature condition is reduced, and it is possible to suppress the wire breaking under vibration.

Therefore, since there is attained reliability equal to or higher than that of the conventional thin gold alloy wire for bonding even if the wire diameter is made smaller than that of the conventional wire, the thin gold alloy wire made according to the invention is suitable for wiring between an electrode of a semiconductor chip with reduced area and an outer lead, and thus it is extremely useful in reducing the size of a semiconductor device and promoting the attainment of a higher density.

The manufacturing method of the present invention is a novel method for manufacturing a thin gold alloy wire for semiconductor chip bonding wherein a gold alloy consisting essentially of the invention's predetermined amounts of elements selected from Pt, Pd, Be, Ge, Ca, La, Y and Eu and the balance being Au and incidental impurity is used as the starting material and is melted, the resulting molten gold alloy is cooled by cooling within a crucible from the lower end toward the upper end of the crucible to afford ingot as a cast product, and the ingot is then subjected to rough machining, drawing and annealing to give a thin gold alloy wire having an elongation of 3 to 8 % and a Young's modulus of 66,687 to 88,263 MPa (6,800 to 9,000 kgf/mm²).
According to this method it is possible to suppress the formation of a chilled layer in the ingot during casting of the gold alloy and produce positively relatively easily a thin gold alloy wire having after annealing an elongation of 3 to 8 % and a high Young's modulus.

Thus, the method in question is suitable for producing positively and inexpensively the novel thin gold alloy wire for bonding referred to above.

## Claims

1. A method of manufacturing a 3-50µm diameter gold alloy wire for semiconductor chip bonding, comprising melting and casting a gold alloy which consists of from 0.01% to 2,2% by weight of at least one of Pt and Pd; from 0.0001% to 0.005% by weight of at least one of Be, Ge, Ca, La Y and Eu; and with the balance being Au and incidental impurity and has an elongation of 3% to 8% and a Young's Modulus of 66,687 to 88,263 Mpa's (6,800 to 9,000 kg/mm²), characterised in that in the melting and casting process the molten gold alloy is cooled within a crucible from the lower end toward the upper end of the crucible and subjecting the resulting ingot to rough machining, drawing and annealing to produce the gold wire.

## Revendications

1. Méthode de fabrication d'un fil en alliage d'or, d'un diamètre de 3-50µm, pour effectuer la fixation de puces de semiconducteurs, comprenant la phase de fusion et de coulage d'un alliage d'or qui se compose de 0,01% à 2,2% par poids d'au moins un de Pt et de Pd ; de 0,0001% à 0,005% par poids d'au moins un de Be, Ge, Ca, La Y et Eu ; alors que le restant est constitué d'or et d'impuretés fortuites, et présente une élongation allant de 3% à 8% et un module de Young situé entre 66.687 et 88.263 Mpa (soit 6.800 à 9.000 kg/mm²), caractérisée en ce que, lors du processus de fusion et de coulage, l'alliage d'or fondu est refroidi dans un creuset à partir de l'extrémité inférieure jusque vers l'extrémité supérieure du creuset, et en ce que le lingot en résultant est soumis à un dégrossissage à la machine, à un étirage et à un recuit afin de produire le fil d'or.

## Patentansprüche

1. Verfahren zur Herstellung eines Goldlegierungsdrahts zum Halbleiterchipbonden mit einem Durchmesser von 3-50 µm, umfassend das Schmelzen und Gießen einer Goldlegierung, die zwischen 0,01 und 2,2 Gew.-% Pt und/oder Pd; zwischen 0,0001 und 0,005 Gew.-% Be, Ge, Ca, La, Y und/oder Eu umfasst, wobei der Rest Au und unerwünschte Fremdstoffe sind, und eine Dehnung zwischen 3% und 8% und einen Youngschen Modul zwischen 66.687 und 88.263 MPa (6800 bis 9000 kg/mm²) aufweist, dadurch gekennzeichnet, dass beim Schmelz- und Gießprozess die geschmolzene Goldlegierung innerhalb eines Tiegels vom unteren Ende in Richtung auf das obere Ende des Tiegels gekühlt und der resultierende Gussblock zur Herstellung des Golddrahtes rohbearbeitet, gezogen und geglüht wird.
